# EUROPÄISCHE PATENTSCHRIFT

(11) **EP 3 993 588 B1**
(45) Veröffentlichungstag und Bekanntmachung des Hinweises auf die Patenterteilung: **03.09.2025**
(21) Anmeldenummer: 21196251.9
(22) Anmeldetag: 13.09.2021
(51) Int. Cl.: H05K 7/20, H01L 23/473

(54) **LEISTUNGSMODUL UND LEISTUNGSELEKTRONISCHES GERÄT**
POWER MODULE AND POWER ELECTRONIC APPARATUS
MODULE DE PUISSANCE ET APPAREIL ÉLECTRONIQUE DE PUISSANCE

(30) Priorität: 29.10.2020 DE 102020213629
(43) Veröffentlichungstag der Anmeldung: 04.05.2022
(73) Patentinhaber: Valeo eAutomotive Germany GmbH, 91056 Erlangen (DE)
(72) Erfinder: Hollweck, Benedikt, 91056 Erlangen (DE); Herold, Christian, 91056 Erlangen (DE); Rayya, Monzer, 91056 Erlangen (DE)
(74) Vertreter: Valeo Powertrain Systems

(56) Entgegenhaltungen:
- EP-A1- 2 824 703
- JP-A- 2012 069 892
- US-A1- 2003 227 732
- US-A1- 2006 243 429
- US-A1- 2010 172 091
- US-A1- 2016 105 997

## Beschreibung

### TECHNISCHES GEBIET

Die Erfindung betrifft ein Leistungsmodul für ein leistungselektronisches Gerät, ein leistungselektronisches Gerät mit einem solchen Leistungsmodul und einen elektrischen Antrieb.

### STAND DER TECHNIK

Je nach Nennleistung können im Betrieb eines Wechselrichters als Beispiel eines leistungselektronischen Gerätes erhebliche Mengen an Abwärme anfallen, die abgeführt werden muss, um den Wechselrichter in einem zulässigen Betriebsbereich zu halten. Insbesondere erwärmen sich die elektronischen Schalter des Leistungsmoduls relativ stark. Leistungsmodule werden bisweilen auch als Powermodule bezeichnet. Zum Teil wird diese Wärme mit Hilfe eines flüssigen Kühlmediums beziehungsweise Wärmeträgers abgeführt. US 2010/172091 A1 betrifft eine Kühlvorrichtung für Halbleiterchips. Nach dem Stand der Technik ist es bekannt, dass schlaufenförmige Kühlvorrichtungen im Kühlmittelstrom angeordnet werden, um die Abwärme vom Leistungsmodul abführen zu können. Dies wird in US 2016/105997 A1 dargestellt. Dies gelingt nur zum Teil in ausreichendem Maße, wodurch die Nennleistung des Wechselrichters doch stark eingegrenzt wird. Ein weiteres Problem ist, dass die Schalter des Leistungsmoduls in der Regel unterschiedlich stark gekühlt werden und unzureichend gekühlte Schalter frühzeitig ausfallen und damit einen Totalausfall des Leistungsmoduls beziehungsweise Wechselrichters verursachen.

### OFFENBARUNG DER ERFINDUNG

Eine Aufgabe der Erfindung ist es daher, ein verbessertes Leistungsmodul für ein leistungselektronisches Gerät, z.B. einen Wechselrichter, ein verbessertes leistungselektronisches Gerät, z.B. einen Stromrichter, insbesondere einen Wechselrichter und einen verbesserten elektrischen Antrieb anzugeben. Insbesondere soll die Kühlung des Leistungsmoduls mit geringerem technischen Aufwand verbessert werden.

Die Aufgabe der Erfindung wird mit einem Leistungsmodul für ein leistungselektronisches Gerät gelöst, welches
- eine Grundplatte mit einer ersten Grundplatten-Seite und einer zweiten, gegenüberliegenden Grundplatten-Seite umfasst,
- steuerbare, elektronische Schalter, welche auf der ersten Grundplatten-Seite angeordnet oder zumindest mit dieser thermisch gekoppelt sind,
- Eingänge und Ausgänge, welche mit den elektronischen Schaltern elektrisch verbunden sind, wobei das Leistungsmodul dazu ausgebildet ist, eine an den Eingängen anliegende Eingangsspannung mittels der elektronischen Schalter in eine an den Ausgängen anliegende Ausgangsspannung umzuwandeln, und
- mehrere auf der zweiten Grundplatten-Seite befestigte oder zumindest mit dieser thermisch gekoppelte Kühlvorrichtungen,
- wobei die Kühlvorrichtungen jeweils mehrere hintereinander angeordnete Schlaufen aufweisen und
- wobei die Schlaufen einer ersten Gruppe der Kühlvorrichtungen und die Schlaufen einer zweiten Gruppe der Kühlvorrichtungen unterschiedlich weit von der zweiten Grundplatten-Seite abstehen.

Die Aufgabe der Erfindung wird auch mit einem leistungselektronischen Gerät gelöst, welcher ein Gerätegehäuse und ein darin angeordnetes erfindungsgemäßes Leistungsmodul umfasst. Dabei wird die Grundplatte des Leistungsmoduls mit der zweiten Grundplatten-Seite auf eine Aufnahme im Gerätegehäuse aufgesetzt, wobei ein Kühlkanal geformt ist, welcher
- teilweise von der zweiten Grundplatten-Seite begrenzt ist,
- die Kühlvorrichtungen aufnimmt,
- einen Einlass zum Anschluss an einen Kühlkreislauf und für einen Zustrom des Kühlfluids aufweist,
- einen Auslass zum Anschluss an den Kühlkreislauf und für einen Abfluss des Kühlfluids aufweist und
- der im Betrieb von einem Kühlfluid in einer Hauptflussrichtung vom Einlass zum Auslass durchströmt wird.

Das leitungselektronische Gerät ist z.B. ein Stromrichter und insbesondere als ein Wechselrichter ausgebildet und umfasst einen im Gerätegehäuse angeordneten Zwischenkreiskondensator, der mit den Eingängen des Leistungsmoduls elektrisch verbunden ist, wobei das Leistungsmodul eingerichtet ist, eine an den Eingängen anliegende Gleichspannung in eine an den Ausgängen anliegende Wechselspannung umzuwandeln.

Schließlich wird die Aufgabe der Erfindung durch einen elektrischen Antrieb gelöst, welcher den erfindungsgemäßen Wechselrichter und eine an die Ausgänge des Leistungsmoduls angeschlossene elektrische Maschine umfasst.

Das Leistungsmodul ist allgemein vorgesehen, die an den Eingängen anliegende Eigenspannung in die an den Ausgängen anliegende Ausgangsspannung umzuwandeln. Die Eingangsspannung ist insbesondere eine Gleichspannung, sodass die Eingänge insbesondere Gleichspannungseingänge sind, und die Ausgangsspannung ist insbesondere ein Wechselspannung, sodass die Ausgänge Wechselspannungsausgänge sind.

Dadurch, dass der Kühlkanal im Betrieb von einem Kühlfluid durchströmt wird, stehen die Kühlvorrichtungen, insbesondre deren Schlaufen, in Kontakt mit dem Kühlfluid beziehungsweise Wärmeträger. Die vorgeschlagenen Maßnahmen führen zu einer verstärkten Verwirbelung des Kühlmediums und damit zu einer verbesserten Kühlleistung. Insbesondere können Kühlleistungen für unterschiedliche Schalter durch lokal vorgesehene Maßnahmen aneinander angeglichen werden, sodass die Schalter des Leistungsmoduls gleichmäßig gekühlt werden. Dadurch kann insbesondere vermieden werden, dass ein sehr früher Ausfall eines einzelnen Schalters zu einem Totalausfall des Leistungsmoduls führt.

Die steuerbaren elektronischen Schalter sind insbesondere steuerbare Halbleiterschalter, wie beispielswiese IGBTs und wandeln die an den Gleichspannungseingängen anliegende Gleichspannung, allgemein an den Eingängen anliegende Eingangsspannung, in allgemein bekannter Weise in eine an den Wechselspannungsausgängen anliegende Wechselspannung, allgemein in eine an den Ausgängen anliegende Ausgangsspannung, um. Die Wechselspannung ist insbesondere eine mehrphasige Wechselspannung, vorzugsweise eine dreiphasige Wechselspannung.

Der Zwischenkreiskondensator des Wechselrichters ist vorgesehen, die Gleichspannung für das Leistungsmodul zu glätten. Die Gleichspannung wird z.B. von einer Batterie, insbesondere von einer wieder aufladbaren Batterie bereitgestellt.

Denkbar ist dabei, dass die Schlaufen der ersten Gruppe und der zweiten Gruppe in unterschiedliche Richtungen geneigt sind, also beide geneigt sind. Mit anderen Worten sind die Schlaufen unterschiedlicher Gruppen von Kühlvorrichtungen in diesem Fall gegenüber einer Normalen auf die zweite Grundplatten-Seite in unterschiedliche Richtungen geneigt. Denkbar ist aber auch, dass die Schlaufen der ersten Gruppe gerade sind, das heißt nicht geneigt sind und nur die Schlaufen der zweiten Gruppe geneigt sind. Mit anderen Worten sind in diesem Fall nur die Schlaufen der zweiten Gruppe gegenüber einer Normalen auf die zweite Grundplatten-Seite geneigt. Die Schlaufen der ersten Gruppe sind dagegen normal auf die zweite Grundplatten-Seite ausgerichtet. Bei der Neigung der Schlaufen der ersten und/oder zweiten Gruppe kann es sich insbesondere um eine deutliche Neigung von wenigstens 3° Grad, insbesondere von wenigstens 5° und vorzugsweise von wenigstens 10° handeln. Vorzugsweise ist die Neigung jedoch weniger als 60°, sodass die deutliche Neigung insbesondere zwischen 3° und 60° liegt.. Diese Neigungswinkel beziehen sich auf eine Normale auf die zweite Grundplatten-Seite.

Zusätzlich oder alternativ dazu können die Schlaufen der ersten Gruppe und der zweiten Gruppe unterschiedlich weit von der zweiten Grundplatten-Seite abstehen. Mit anderen Worten ist dann eine normal beziehungsweise rechtwinkelig auf die zweiten Grundplatten-Seite gemessene Höhe unterschiedlicher Gruppe voneinander verschieden.

Die Schlaufen können durch entsprechend geformte Metallstreifen der Kühlvorrichtungen gebildet sein. Eine Kühlvorrichtung kann durch einen Metallstreifen gebildet sein, der zu mehreren Schlaufen geformt ist, die in der Längsrichtung der Kühlvorrichtung hintereinander liegen. Beispielsweise können die Metallstreifen auf der Grundplatte aufgelötet oder aufgeschweißt werden. Häufig werden die Metallstreifen auch im Rahmen eines "Bonding-Prozesses", mit dem auch integrierte Schaltkreise verdrahtet werden, auf der Grundplatte angebracht.

Die Kühlvorrichtung weist allgemein eine Höhe auf, die normal auf die zweite Grundplatten-Seite gemessen wird, eine Länge, die normal auf die Höhe gemessen wird, und eine Breite, die normal auf die Höhe und die Länge gemessen wird, wobei die Breite kleiner ist als die Länge.

Beispielsweise kann an die Gleichspannungseingänge eine Batterie oder ein Ackumulator angeschlossen sein und an die Wechselspannungsausgänge eine elektrische Maschine, beispielweise eine permanenterregte Synchronmaschine oder eine Asynchronmaschine. Vorzugsweise sind diese als Drehstrommaschinen ausgebildet, also dreiphasig.

An den Gleichspannungseingängen kann auch ein Zwischenkreiskondensator zur Glättung der von der Batterie oder dem Akkumulator gelieferten Gleichspannung vorgesehen sein (z.B. um Leistungsspitzen auszugleichen).

Die elektronischen Schalter können insbesondere paarweise in Serie geschaltet sein und mehrere Halbbrücken bilden. Die Gleichspannungseingänge sind dabei mit den äußeren Polen der Halbbrücken verbunden, die Wechselspannungsausgänge mit den mittleren Polen der Halbbrücke. Insbesondere können die Wechselspannungsausgänge dreiphasig ausgebildet sein. Durch entsprechendes, allgemein bekanntes Ansteuern der Halbbrücken kann eine an den Gleichspannungseingängen anliegende Gleichspannung in eine an den Wechselspannungsausgängen anliegende Wechselspannung umgewandelt werden.

Das Leistungsmodul kann auch ein Gehäuse aufweisen, das die elektronischen Schalter aufnimmt und diese vor Umwelteinflüssen schützt.

Der Kühlkanal kann quaderförmig oder zumindest quaderartig ausgebildet sein, wobei eine Höhe des Kühlkanals normal auf die zweite Grundplatten-Seite gemessen wird und eine Länge des Kühlkanals größer ist als eine Breite des Kühlkanals.

Das leistungselektronische Gerät bzw. der Wechselrichter kann auch ein Gerätegehäuse aufweisen, welches eine Treiberstufe für die elektronischen Schalter aufnimmt sowie gegebenenfalls eine Steuervorrichtung für die Treiberstufe. Die Treiberstufe ist normalerweise nicht Teil des Leistungsmoduls, kann aber zumindest teilweise im Leistungsmodul verbaut sein. Das Gerätegehäuse kann auch weitere Kühlkanäle für die Kühlung weiterer Baueinheiten aufweisen. Die Steuervorrichtung kann zudem eine Regelung für einen Antrieb realisieren, welcher den Wechselrichter und eine an die Wechselspannungsausgänge des Leistungsmoduls angeschlossene elektrische Maschine umfasst.

Vorzugsweise ist der Kühlkanal für das Leistungsmodul zumindest teilweise im Wechselrichtergehäuse integriert.

Das Gerätegehäuse ist vorzugsweise aus Metall, z.B. aus Aluminium.

Der elektrischer Antrieb kann auch ein Gehäuse aufweisen, welche eine Steuervorrichtung für die Treiberstufe beziehungsweise eine Regelung für den elektrischen Antrieb aufnimmt. Ist eine Regelung für die elektrische Maschine vorhanden, handelt es sich bei dem elektrischen Antrieb um einen geregelten elektrischen Antrieb. Der elektrische Antrieb kann auch ein an die elektrische Maschine angeschlossenes Getriebe umfassen. Der elektrische Antrieb kann, wie bereits weiter oben erwähnt, im Speziellen für den Antrieb eines Fahrzeugs eingesetzt werden.

Weitere vorteilhafte Ausgestaltungen und Weiterbildungen der Erfindung ergeben sich aus den Unteransprüchen sowie aus der Beschreibung in Zusammenschau mit den Figuren.

Vorteilhaft sind durch die Schlaufen gebildete Augen benachbarter Kühlvorrichtungen in einer Längsrichtung der Kühlvorrichtungen zueinander versetzt. Dadurch kann die Verwirbelung des Kühlmediums im Bereich der Schlaufen weiter gesteigert und damit die Kühlwirkung der Kühlvorrichtung weiter verbessert werden. Denkbar wäre aber auch, dass die Schlaufen der Kühlvorrichtung matrixförmig angeordnet sind.

Vorteilhaft ist es weiterhin, wenn alle Augen, welche durch die Schlaufen gebildet sind, in dieselbe Richtung zeigen. Dadurch bleibt der Strömungswiderstand der Kühlvorrichtungen gering. Denkbar wäre aber auch, dass die Augen, welche durch die Schlaufen einer Kühlvorrichtung gebildet sind, alle in unterschiedliche Richtungen zeigen. Zudem können die Augen der Schlaufen aller Kühlvorrichtungen in dieselbe Richtung zeigen, oder die Augen der Schlaufen verschiedener Kühlvorrichtungen können auch in unterschiedliche Richtung zeigen.

Vorteilhaft ist es weiterhin, wenn die Schlaufen gegenüber der Längsrichtung der Kühlvorrichtung verdreht sind. Im Speziellen ist damit gemeint, dass die Schlaufen gegenüber der Längsrichtung der Kühlvorrichtung um eine normal auf die zweiten Grundplatten-Seite verlaufende Hochachse der Kühlvorrichtungen verdreht sein können, das heißt nicht nur gegenüber einer Normalen auf die zweiten Grundplatten-Seite geneigt sein können. Sind die Schlaufen durch entsprechend geformte Metallstreifen der Kühlvorrichtungen gebildet, so stehen vor allem zwei Möglichkeiten zur Verfügung. Beispielsweise können Abschnitte des Metallstreifens, welche zwischen den Schlaufen liegen, in Querrichtung der Kühlvorrichtung seitlich zueinander versetzt werden, wodurch automatisch eine Verdrehung der Schlaufen entsteht, oder es werden die Schlaufen ohne seitlichen Versatz des Metallstreifens verdreht. Durch die Verdrehung der Schlaufen kann die Verwirbelung des Kühlmediums im Bereich der Schlaufen weiter gesteigert und damit die Kühlwirkung der Kühlvorrichtung weiter verbessert werden.

Besonders vorteilhaft ist es weiterhin, wenn
a) ein Anteil an benachbarten Kühlvorrichtungen, deren Schlaufen zueinander geneigt sind, im Bereich eines ersten Schalters der Schalter größer ist als im Bereich eines zweiten Schalters der Schalter und/oder
b) die Höhe der Kühlvorrichtungen im Bereich des ersten Schalters größer ist als im Bereich des zweiten Schalters und/oder
c) ein Anteil an benachbarten Kühlvorrichtungen, deren Schlaufen in einer Längsrichtung der Kühlvorrichtungen zueinander versetzt sind, im Bereich des ersten Schalters größer ist als im Bereich des zweiten Schalters und/oder
d) ein Versatz von Schlaufen benachbarter Kühlvorrichtungen im Bereich des ersten Schalters geringer ist als im Bereich des zweiten Schalters und/oder
e) ein Anteil an benachbarten Kühlvorrichtungen, deren Augen in unterschiedliche Richtungen zeigen, im Bereich des ersten Schalters größer ist als im Bereich des zweiten Schalters und/oder
f) eine Verdrehung von Schlaufen benachbarter Kühlvorrichtungen im Bereich des ersten Schalters größer ist als im Bereich des zweiten Schalters.

Günstig ist es in obigem Zusammenhang, wenn der erste Schalter gegenüber dem zweiten Schalter in der Hauptflussrichtung des Kühlfluids stromabwärts angeordnet ist. Mit anderen Worten liegt der erste Schalter dem Auslass des Kühlkanals näher, und der zweite Schalter liegt dem Einlass des Kühlkanals näher. Demzufolge kann vorgesehen sein, dass
i) ein Anteil an benachbarten Kühlvorrichtungen, deren Schlaufen zueinander geneigt sind, bezogen auf die Hauptflussrichtung des Kühlfluids, stromaufwärts geringer ist als stromabwärts beziehungsweise ein Anteil an benachbarten Kühlvorrichtungen, deren Schlaufen zueinander geneigt sind, in der Nähe des Einlasses des Kühlkanals geringer ist als in der Nähe des Auslasses des Kühlkanals und/oder
ii) die Höhe der Kühlvorrichtungen, bezogen auf die Hauptflussrichtung des Kühlfluids, stromaufwärts geringer ist als stromabwärts beziehungsweise die Höhe der Kühlvorrichtungen in der Nähe des Einlasses des Kühlkanals geringer ist als in der Nähe des Auslasses des Kühlkanals und/oder
iii) ein Anteil an benachbarten Kühlvorrichtungen, deren Schlaufen in einer Längsrichtung der Kühlvorrichtungen zueinander versetzt sind, bezogen auf die Hauptflussrichtung des Kühlfluids, stromaufwärts geringer ist als stromabwärts beziehungsweise ein Anteil an benachbarten Kühlvorrichtungen, deren Schlaufen in einer Längsrichtung der Kühlvorrichtungen zueinander versetzt sind, in der Nähe des Einlasses des Kühlkanals geringer ist als in der Nähe des Auslasses des Kühlkanals und/oder
iv) ein Versatz von Schlaufen benachbarter Kühlvorrichtungen, bezogen auf die Hauptflussrichtung des Kühlfluids, stromabwärts geringer ist als stromaufwärts beziehungsweise ein Versatz von Schlaufen benachbarter Kühlvorrichtungen in der Nähe des Auslasses des Kühlkanals geringer ist als in der Nähe des Einlasses des Kühlkanals und/oder
v) ein Anteil an benachbarten Kühlvorrichtungen, deren Augen in unterschiedliche Richtungen zeigen, stromaufwärts geringer ist als stromabwärts beziehungsweise ein Anteil an benachbarten Kühlvorrichtungen, deren Augen in unterschiedliche Richtungen zeigen, in der Nähe des Einlasses des Kühlkanals geringer ist als in der Nähe des Auslasses des Kühlkanals und/oder
vi) eine Verdrehung von Schlaufen benachbarter Kühlvorrichtungen, bezogen auf die Hauptflussrichtung des Kühlfluids, stromaufwärts geringer ist als stromabwärts beziehungsweise eine Verdrehung von Schlaufen benachbarter Kühlvorrichtungen in der Nähe des Einlasses des Kühlkanals geringer ist als in der Nähe des Auslasses des Kühlkanals.

Durch die vorgeschlagenen Maßnahmen kann eine Kühlwirkung für unterschiedliche Schalter gezielt beeinflusst werden. Beispielsweise kann eine Kühlleistung für alle Schalter gleich sein, obwohl sich die Temperatur des Kühlmediums unterschiedlich ist. Die in den Punkten a) bis f) beziehungsweise i) bis vi) offenbarten Maßnahmen können sich graduell ändern oder auch sprunghaft. Mit anderen Worten kann eine Änderung der in den Punkten a) bis f) oder i) bis vi) offenbarten Maßnahmen von Kühlvorrichtung zu Kühlvorrichtung erfolgen, oder es erfolgt eine relativ drastische Änderung zwischen zwei benachbarten Kühlvorrichtungen, und die Maßnahmen bleiben dann über mehrere Kühlvorrichtungen hinweg konstant. Insbesondere können die in einem Bereich eines Schalters ergriffenen Maßnahmen gleich bleiben, zwischen mehreren oder allen Schaltern aber Unterschiede in den ergriffenen Maßnahmen vorliegen.

Günstig ist es, wenn eine Längsrichtung der Kühlvorrichtungen quer zur Hauptflussrichtung des Kühlfluids ausgerichtet ist und Augen, welche durch die Schlaufen gebildet sind, in Richtung der Hauptflussrichtung des Kühlfluids offen sind. Dadurch bleibt der Strömungswiderstand der Kühlvorrichtungen gering.

Besonders vorteilhaft ist es schließlich, wenn sich die in den Punkten a) bis f) oder i) bis vi) ergriffenen Maßnahmen für eine Gruppe erster Schalter, welche einer Halbbrücke des Wechselrichters zugeordnet sind, von den in den Punkten a) bis f) oder i) bis vi) ergriffenen Maßnahmen für eine Gruppe zweiter Schalter, welche anderen Halbbrücken des Wechselrichters zugeordnet sind, unterscheiden, innerhalb einer Gruppe jedoch keine Unterschiede der in den Punkten a) bis f) oder i) bis vi) ergriffenen Maßnahmen vorgesehen sind, wobei die ersten Schalter gegenüber den zweiten Schaltern in einer Hauptflussrichtung des Kühlfluids stromabwärts angeordnet sind. Mit anderen Worten kann insbesondere vorgesehen sein, dass sich im Hinblick auf die in den Punkten a) bis f) oder i) bis vi) ergriffenen Maßnahmen nur die Schalter einer am weitesten stromabwärts angeordneten Halbbrücke von den Schaltern aller anderen Halbbrücken unterscheiden. Die Schalter einer am weitesten stromabwärts angeordneten Halbbrücke werden nach dem Stand der Technik häufig nur unzureichend gekühlt weil das Kühlmedium durch die stromaufwärts gelegenen Schalter schon erwärmt wurde. Durch die vorgeschlagenen Maßnahmen kann aber ein Ausgleich geschaffen werden. Das heißt, eine Kühlleistung kann für alle Schalter gleich sein, obwohl sich die Temperatur des Kühlmediums unterschiedlich ist.

Die obigen Ausgestaltungen und Weiterbildungen der Erfindung lassen sich auf beliebige Art und Weise kombinieren.

### KURZE BESCHREIBUNG DER FIGUREN

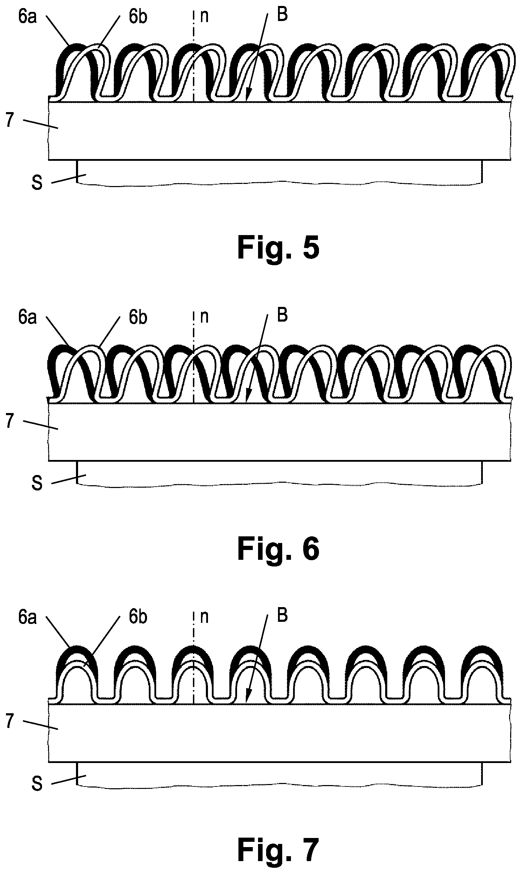

Ausführungsbeispiele der Erfindung sind exemplarisch in den beigefügten schematischen Figuren dargestellt. Die Ausführungsformen der Figuren 7 und sind von den Patentansprüchen erfasst. Die Ausführungsformen der Figuren 5, 6, 8 und 9 sind nicht durch die Patentansprüche gedeckt. Die Ausführungsformen der übrigen Figuren dienen dem Verständnis der Erfindung. Es zeigen:
- Fig. 1: ein elektrisches Prinzipschaltbild eines Leistungsmoduls, eines Wechselrichters als Beispiels eines leistungselektronischen Gerätes und eines elektrischen Antriebs;
- Fig. 2: eine schematische Darstellung des Leistungsmoduls in Schrägansicht von oben;
- Fig. 3: das Leistungsmodul aus Fig. 2 in Explosionsdarstellung in Schrägansicht von oben;
- Fig. 4: das Leistungsmodul aus Fig. 2 in Explosionsdarstellung in Schrägansicht von unten;
- Fig. 5: eine Kühlvorrichtung in Vorderansicht mit gegeneinander geneigten Schlaufen;
- Fig. 6: eine Kühlvorrichtung in Vorderansicht mit Schlaufen, die in gegensätzliche Richtungen geneigt sind;

- Fig. 7: eine Kühlvorrichtung in Vorderansicht mit unterschiedlich weit von der Grundplatte abstehenden Schlaufen;
- Fig. 8: eine Kühlvorrichtung in Vorderansicht mit einfach versetzten Schlaufen;
- Fig. 9: eine Kühlvorrichtung in Vorderansicht mit zweifach versetzten Schlaufen;
- Fig. 10: eine Kühlvorrichtung in Vorderansicht mit geneigten, unterschiedlich hohen und versetzten Schlaufen;
- Fig. 11: eine Kühlvorrichtung in Draufsicht mit verdrehten Schlaufen ohne seitlichen Versatz des Metallstreifens;
- Fig. 12: eine Kühlvorrichtung in Draufsicht mit verdrehten Schlaufen mit seitlichem Versatz des Metallstreifens;
- Fig. 13: eine Draufsicht auf die zweite Grundplatten-Seite, in der die Kühlvorrichtungen 5 schematisiert als Pfeile dargestellt sind, und Maßnahmen für die Schlaufen gleichverteilt sind;
- Fig. 14: ähnlich wie Fig. 13, nur mit Schlaufen, die im Bereich von Gruppen erster und zweiter Schalter unterschiedlich geneigt sind;
- Fig. 15: ebenfalls ähnlich wie Fig. 13 und mit Schlaufen, die im Bereich von Gruppen erster und zweiter Schalter unterschiedlich geneigt sind;
- Fig. 16: ähnlich wie Fig. 13, nur mit Schlaufen, die im Bereich von Gruppen erster und zweiter Schalter unterschiedlich geneigt und versetzt sind;
- Fig. 17: ähnlich wie Fig. 13, nur mit Schlaufen, die im Bereich von Gruppen erster und zweiter Schalter unterschiedlich geneigt und verdreht sind und
- Fig. 18: ein schematisch dargestelltes Fahrzeug mit einem elektrischen Antrieb der vorgeschlagenen Art.

### DETAILIERTE BESCHREIBUNG DER ERFINDUNG

Einführend wird festgehalten, dass gleiche Teile in den unterschiedlich Ausführungsformen mit gleichen Bezugszeichen beziehungsweise gleichen Bauteilbezeichnungen versehen werden, gegebenenfalls mit unterschiedlichen Indizes. Die in der Beschreibung enthaltene Offenbarungen eines Bauteils kann sinngemäß ein anderes Bauteil mit gleichem Bezugszeichen beziehungsweise gleicher Bauteilbezeichnung übertragen werden. Auch sind die in der Beschreibung gewählten Lageangaben, wie zum Beispiel "oben", "unten", "hinten", "vorne", "seitlich" und so weiter auf die unmittelbar beschriebene sowie dargestellte Figur bezogen und bei einer Lageänderung sinngemäß auf die neue Lage zu übertragen.

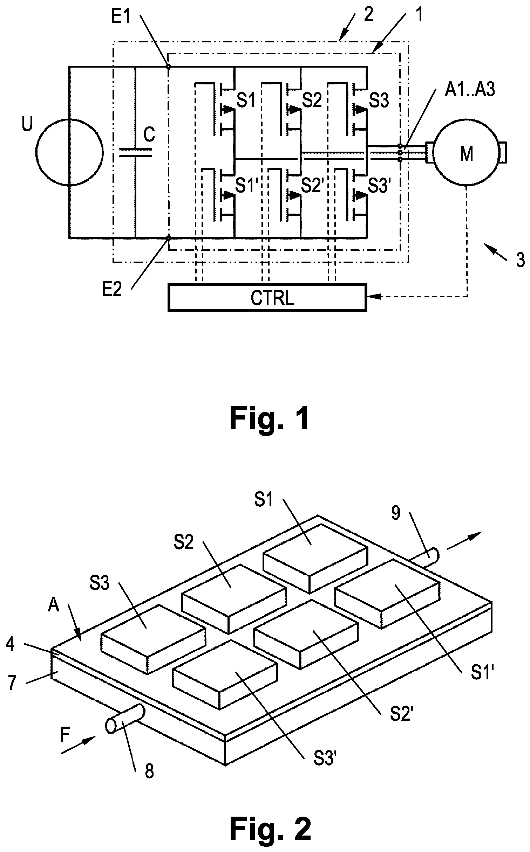

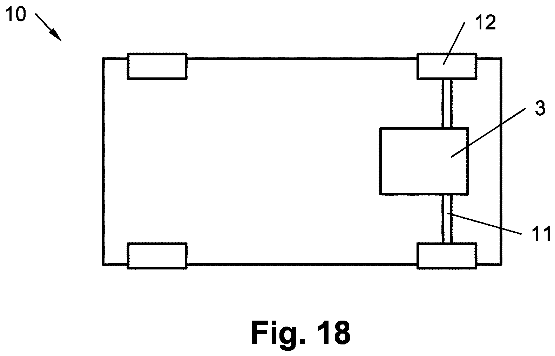

Fig. 1 zeigt ein elektrisches Prinzipschaltbild eines Leistungsmoduls 1 für einen Wechselrichter 2, eines Wechselrichters 2 und eines elektrischen Antriebs 3. Das Leistungsmodul 1 umfasst mehrere steuerbare, elektronische Schalter S1..S3' sowie Gleichspannungseingänge E1, E2 und Wechselspannungsausgänge A1..A3, welche mit den elektronischen Schaltern S1..S3' elektrisch verbunden sind. Der Wechselrichter 2 umfasst das Leistungsmodul 1 sowie einen Zwischenkreiskondensator C, der mit den Gleichspannungseingängen E1, E2 des Leistungsmoduls 1 elektrisch verbunden ist. An die Gleichspannungseingänge E1, E2 ist zudem eine Batterie oder ein Akkumulator angeschlossen, welcher eine Gleichspannung U liefert. An die Wechselspannungsausgänge A1..A3 ist eine elektrische Maschine M angeschlossen. Der Wechselrichter 2 und die elektrische Maschine M bilden einen elektrischen Antrieb 3. Der Wechselrichter 2 kann auch eine Treiberstufe für die elektronischen Schalter S1..S3' aufweisen sowie eine Steuervorrichtung CTRL für die Treiberstufe. In der Fig. 1 ist die Treiberstufe nicht gesondert dargestellt, sondern Teil der Steuervorrichtung CTRL. Die Steuervorrichtung CTRL kann zudem eine Regelung für den elektrischen Antrieb 3 realisieren, welche durch die von der elektrische Maschine M wegführende Messleitung angedeutet ist. In diesem Fall handelt es sich bei dem elektrischen Antrieb 3 um einen geregelten elektrischen Antrieb. Der elektrische Antrieb 3 kann auch ein an die elektrische Maschine M angeschlossenes Getriebe umfassen. Der elektrische Antrieb 3 kann im Speziellen für den Antrieb eines Fahrzeugs eingesetzt werden (siehe auch Fig. 18). Die elektrische Maschine M kann beispielweise als permanenterregte Synchronmaschine oder Asynchronmaschine ausgebildet sein. Vorzugsweise ist diese als Drehstrommaschine ausgebildet, also dreiphasig.

Das Leistungsmodul 1 und der Wechselrichter 2 wesen auch jeweils ein eigenes, in der Fig. 1 nicht dargestelltes Gehäuse auf. Das Gehäuse des Leistungsmoduls 1 kann die elektronischen Schalte S1..S3' aufnehmen und diese vor Umwelteinflüssen schützen. Das Gehäuse des Wechselrichters 2 kann auch die Treiberstufe für die elektronischen Schalter S1..S3' aufnehmen sowie gegebenenfalls die Steuervorrichtung CTRL. Die Treiberstufe ist normalerweise nicht Teil des Leistungsmoduls 1, kann aber zumindest teilweise im Leistungsmodul 1 verbaut sein.

Durch entsprechendes, allgemein bekanntes Ansteuern der Halbbrücken kann eine an den Gleichspannungseingängen E1, E2 anliegende Gleichspannung U in eine an den Wechselspannungsausgängen A1..A3 anliegende Wechselspannung umgewandelt werden. Die elektronischen Schalter S1..S3' sind in diesem Beispiel dazu paarweise in Serie geschaltet und bilden mehrere Halbbrücken. Die Gleichspannungseingänge E1, E2 sind dabei mit den äußeren Polen der Halbbrücken verbunden, die Wechselspannungsausgänge A1..A3 mit den mittleren Polen der Halbbrücke. Der Zwischenkreiskondensator C dient dabei zur Glättung der von der Batterie oder dem Akkumulator gelieferten Gleichspannung U, zum Beispiel um Leistungsspitzen auszugleichen.

Das Leistungsmodul 1 ist in diesem Beispiel dreiphasig ausgebildet, es könnte aber auch eine andere Anzahl an Phasen vorgesehen sein.

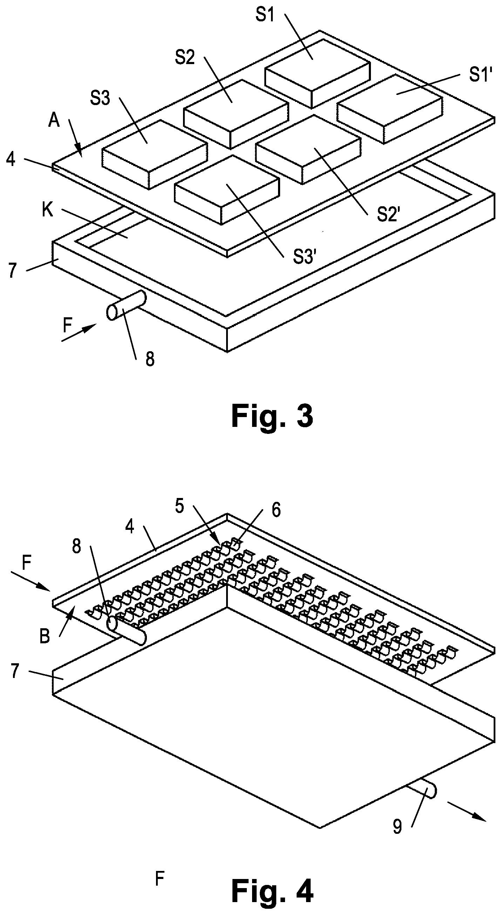

Die Fig. 2 bis 4 zeigen eine schematische Darstellung des Leistungsmoduls 1, die Fig. 2 in Schrägansicht von oben, die Fig. 3 in Explosionsdarstellung in Schrägansicht von oben und die Fig. 4 in Explosionsdarstellung in Schrägansicht von unten.

Das Leistungsmodul 1 umfasst eine Grundplatte 4 mit einer ersten Grundplatten-Seite A und einer zweiten, gegenüberliegenden Grundplatten-Seite B. Die steuerbaren, elektronischen Schalter S1..S3' sind auf der ersten Grundplatten-Seite A angeordnet oder zumindest mit dieser thermisch gekoppelt. Auf der zweiten Grundplatten-Seite B sind mehrere Kühlvorrichtungen 5 befestigt oder zumindest mit dieser thermisch gekoppelt. Die Kühlvorrichtungen 5 weisen jeweils mehrere hintereinander angeordnete Schlaufen 6 auf. Die Schlaufen 6 können durch entsprechend geformte Metallstreifen der Kühlvorrichtungen 5 gebildet sein. Anders gesagt kann eine Kühlvorrichtung 5 durch einen Metallstreifen gebildet sein, der zu mehreren Schlaufen 6 geformt ist, die in der Längsrichtung der Kühlvorrichtung 5 hintereinander liegen. Die Metallstreifen können auf der Grundplatte 4 aufgelötet oder aufgeschweißt werden insbesondere im Rahmen eines "Bonding-Prozesses".

Der Wechselrichter 2 weist eine Aufnahme 7 im Wechselrichtergehäuse auf, auf welche die Grundplatte 4 mit der zweiten Grundplatten-Seite B aufgesetzt wird. das Wechselrichtergehäuse ist in den Fig. 2 bis 4 lediglich schematisch dargestellt beziehungsweise nur in jenen Teilen, welche mit dem Leistungsmodul 1 zusammenwirken. Das Wechselrichtergehäuse kann insbesondere größer sein als dargestellt und auch anders geformt sein. Durch das Aufsetzen der Grundplatte 4 auf die Aufnahme 7 wird ein Kühlkanal K geformt, der teilweise von der zweiten Grundplatten-Seite B begrenzt ist und die Kühlvorrichtungen 5 aufnimmt. Zudem weist der Kühlkanal K einen Einlass 8 zum Anschluss an einen Kühlkreislauf und für einen Zustrom eines Kühlfluids auf, sowie einen Auslass 9 zum Anschluss an den Kühlkreislauf und für einen Abfluss des Kühlfluids. Im Betrieb wird der Kühlkanal K von dem Kühlfluid in einer mit Pfeilen angegebenen Hauptflussrichtung F vom Einlass 8 zum Auslass 9 durchströmt. Dadurch stehen die Kühlvorrichtungen 5 direkt in Kontakt mit dem Kühlfluid beziehungsweise Wärmeträger. Die Kühlung im Wechselrichter 2 ist nicht auf das Leistungsmodul 1 beschränkt, sondern das Wechselrichtergehäuse kann auch weitere Kühlkanäle für die Kühlung weiterer Baueinheiten aufweisen.

Der Kühlkanal K kann, wie in den Fig. 2 bis 4 dargestellt ist quaderförmig sein oder auch zum Beispiel gerundete Ecken und Kanten aufweisen und somit quaderartig ausgebildet sein. Eine Höhe des Kühlkanals K wird generell normal beziehungsweise rechtwinkelig auf die zweite Grundplatten-Seite B gemessen. Eine Länge des Kühlkanals K größer ist als eine Breite des Kühlkanals K.

Die Fig. 5 bis 10 zeigen nun verschiedene Anordnungen der Kühlvorrichtungen 5 beziehungsweise Schlaufen 6, jeweils in Vorderansicht beziehungsweise in Blickrichtung der Hauptflussrichtung F des Kühlfluids. Die Schlaufen 6a einer ersten Gruppe von Kühlvorrichtungen 5 sind dabei in Schwarz dargestellt, die Schlaufen 6b einer zweiten Gruppe in Weiß.

In dem in Fig. 5 dargestellten Beispiel sind die Schlaufen 6a der ersten Gruppe gerade, das heißt nicht geneigt, und nur die Schlaufen 6b der zweiten Gruppe sind geneigt. Mit anderen Worten sind in diesem Fall nur die Schlaufen 6b der zweiten Gruppe gegenüber einer Normalen n auf die zweite Grundplatten-Seite B geneigt. Die Schlaufen 6a der ersten Gruppe sind dagegen normal auf die zweite Grundplatten-Seite B ausgerichtet.

In dem in Fig. 6 dargestellten Beispiel sind die Schlaufen 6a der ersten Gruppe und die Schlaufen 6b der zweiten Gruppe in unterschiedliche Richtungen geneigt, es sind also beide geneigt. Mit anderen Worten sind die Schlaufen 6a, 6b unterschiedlicher Gruppen von Kühlvorrichtungen 5 in diesem Fall gegenüber einer Normalen n auf die zweite Grundplatten-Seite B in unterschiedliche Richtungen geneigt. Denkbar wäre auch, dass die Schlaufen 6a, 6b unterschiedlicher Gruppen von Kühlvorrichtungen 5 in dieselbe Richtung geneigt sind, jedoch unterschiedliche Neigungswinkel aufweisen.

Bei der Neigung der Schlaufen 6a, 6b der ersten und/oder zweiten Gruppe kann es sich generell um eine deutliche Neigung von z.B. mehr als 3° Grad handeln.

Fig. 7 zeigt die von den Ansprüchen umfasste Ausführungsform, bei der die Schlaufen 6a einer ersten Gruppe der Kühlvorrichtungen 5 und die Schlaufen 6b einer zweiten Gruppe der Kühlvorrichtungen 5 unterschiedlich weit von der zweiten Grundplatten-Seite B abstehen. Mit anderen Worten ist dann eine normal beziehungsweise rechtwinkelig auf die zweiten Grundplatten-Seite B gemessene Höhe unterschiedlicher Gruppe voneinander verschieden.

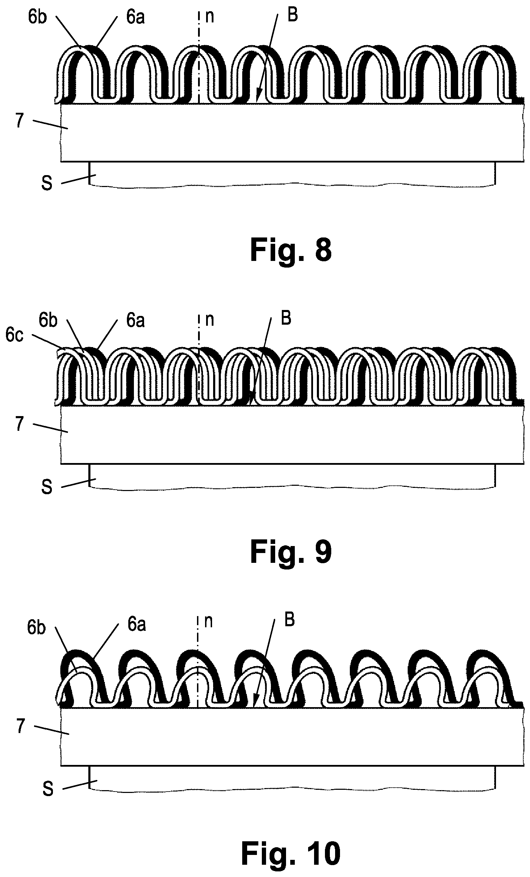

Fig. 8 und 9 zeigen Beispiele, bei dem durch die Schlaufen 6a..6c gebildete Augen benachbarter Kühlvorrichtungen 5 in einer Längsrichtung der Kühlvorrichtungen 5 zueinander versetzt sind. In der Fig. 8 liegt ein einfacher Versatz vor, in der Fig. 9 ein zweifacher Versatz. Der Versatz in der Fig. 8 ist somit größer als in der Fig. 9. Denkbar wäre aber auch, dass die Schlaufen 6a, 6b der Kühlvorrichtungen 5 matrixförmig angeordnet sind, also nicht versetzt sind.

Die angegebenen Maßnahmen können auch in beliebiger Kombination vorgenommen werden. Das heißt die Schlaufen 6a einer ersten Gruppe und die Schlaufen 6b einer zweiten Gruppe können geneigt und unterschiedlich hoch sein, unterschiedlich hoch und versetzt sowie geneigt, unterschiedlich hoch und versetzt sein. Eine Ausführungsform für geneigte, unterschiedlich hohe und versetzte Schlaufen 6a, 6b ist stellvertretend in Fig. 10 dargestellt.

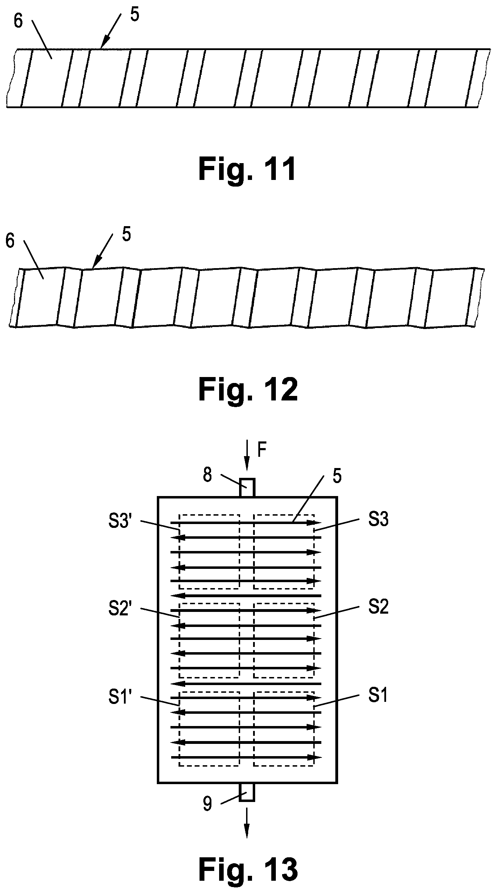

In einer weiteren Ausführungsform sind die Schlaufen 6 gegenüber der Längsrichtung der Kühlvorrichtung 5 verdreht. Im Speziellen ist damit gemeint, dass die Schlaufen 6 gegenüber der Längsrichtung der Kühlvorrichtung 5 um eine normal auf die zweiten Grundplatten-Seite verlaufende Hochachse n der Kühlvorrichtungen 5 verdreht sein können. Sind die Schlaufen 6 durch entsprechend geformte Metallstreifen der Kühlvorrichtungen gebildet, so stehen vor allem zwei Möglichkeiten zur Verfügung. Beispielsweise können Abschnitte des Metallstreifens, welche zwischen den Schlaufen 6 liegen, ohne seitlichen Versatz des Metallstreifens verdreht sein, so wie das in der Fig. 11 dargestellt ist. Denkbar ist aber auch, dass eine Verdrehung oder der Schlaufen 6 durch seitlichen Versatz der Abschnitte des Metallstreifens, welche zwischen den Schlaufen 6 liegen, in Querrichtung der Kühlvorrichtung 5 erfolgt, so wie das in der Fig. 12 dargestellt ist. Durch diesen Versatz entsteht automatisch eine Verdrehung der Schlaufen 6.

Generell ist vorstellbar, dass alle Augen, welche durch die Schlaufen 6 gebildet sind, in dieselbe Richtung zeigen. Denkbar wäre aber auch, dass die Augen, welche durch die Schlaufen 6 einer Kühlvorrichtung 5 gebildet sind, alle in unterschiedliche Richtungen zeigen. Zudem können die Augen der Schlaufen 6 aller Kühlvorrichtungen 5 in dieselbe Richtung zeigen, oder die Augen der Schlaufen 6 verschiedener Kühlvorrichtungen 5 können auch in unterschiedliche Richtung zeigen.

Generell ist eine Längsrichtung der Kühlvorrichtungen 5 vorzugsweise quer zur Hauptflussrichtung F des Kühlfluids ausgerichtet, und die Augen, welche durch die Schlaufen 6 gebildet sind, sind in Richtung der Hauptflussrichtung F des Kühlfluids offen.

An dieser Stelle wird angemerkt, dass auch eine Verdrehung der Schlaufen 6 in beliebiger Kombination mit einer Neigung der Schlaufen 6, mit einer unterschiedlichen Höhe der Schlaufen 6 oder mit einem Versatz der Schlaufen 6 angewendet werden kann.

Generell können die vorgeschlagenen Maßnahmen über die gesamte zweite Grundplatten-Seite B beziehungsweise über die gesamte zweite Grundplatten-Seite B im Bereich der Schalter S1..S3' gleichverteilt angewandt werden. Fig. 13 zeigt dazu ein Beispiel in Draufsicht auf die zweite Grundplatten-Seite B, in dem die Kühlvorrichtungen 5 schematisiert als Pfeile dargestellt sind. Die Pfeile geben dabei die Neigungsrichtung der Schlaufen 6a, 6b an. In dem gezeigten Beispiel sind die Schlaufen 6a, 6b benachbarter Kühlvorrichtungen 5 jeweils gegenseitig geneigt, so wie das auch in der Fig. 6 dargestellt ist. Die Pfeile stehen in der Fig. 13 stellvertretend für die Neigung der Schlaufen 6a, 6b, sie können aber auch eine unterschiedliche Höhe der Schlaufen 6a, 6b, einen Versatz der Schlaufen 6a, 6b oder eine unterschiedliche Verdrehung der Schlaufen 6a, 6b sowie eine beliebige Kombination der vorgeschlagenen Maßnahmen andeuten. Beispielweise kann ein nach rechts weisender Pfeil höhere Schlaufen 6a und ein nach links weisender Pfeil Schlaufen 6b niedrigerer Höhe angeben (siehe auch Fig. 7). Ein nach rechts weisender Pfeil kann auch nach rechts versetzte Schlaufen 6a und ein nach links weisender Pfeil nach links versetzte Schlaufen 6b angeben (siehe auch Fig. 8). Ein nach rechts weisender Pfeil kann auch nach rechts verdrehte Schlaufen 6a und ein nach links weisender Pfeil nach links verdrehte Schlaufen 6b angeben (siehe auch Fig. 11 und 12).

Die Gleichverteilung der vorgeschlagenen Maßnahmen ist jedoch nicht zwingend. Von Vorteil ist es bei einem Leistungsmodul 1 auch, wenn
a) ein Anteil an benachbarten Kühlvorrichtungen 5, deren Schlaufen 6a, 6b zueinander geneigt sind, im Bereich eines ersten Schalters S1, S1' der Schalter S1..S3' größer ist als im Bereich eines zweiten Schalters S2, S2' der Schalter S1..S3' und/oder
b) die Höhe der Kühlvorrichtungen 5 im Bereich des ersten Schalters S1, S1' größer ist als im Bereich des zweiten Schalters S2, S2' und/oder
c) ein Anteil an benachbarten Kühlvorrichtungen 5, deren Schlaufen 6a, 6b in einer Längsrichtung der Kühlvorrichtungen 5 zueinander versetzt sind, im Bereich des ersten Schalters S1, S1' größer ist als im Bereich des zweiten Schalters S2, S2' und/oder
d) ein Versatz von Schlaufen 6a, 6b benachbarter Kühlvorrichtungen 5 im Bereich des ersten Schalters S1, S1' geringer ist als im Bereich des zweiten Schalters S2, S2' und/oder
e) ein Anteil an benachbarten Kühlvorrichtungen 5, deren Augen in unterschiedliche Richtungen zeigen, im Bereich des ersten Schalters S1, S1' größer ist als im Bereich des zweiten Schalters S2, S2' und/oder
f) eine Verdrehung von Schlaufen 6a, 6b benachbarter Kühlvorrichtungen 5 im Bereich des ersten Schalters S1, S1' größer ist als im Bereich des zweiten Schalters S2, S2'.

Vorzugsweise ist der erste Schalter S1, S1' gegenüber dem zweiten Schalter S2, S2' dabei in der Hauptflussrichtung F des Kühlfluids stromabwärts angeordnet. Mit anderen Worten liegt der erste Schalter S1, S1' dem Auslass 9 des Kühlkanals K näher, und der zweite Schalter S2, S2' liegt dem Einlass 8 des Kühlkanals K näher. Demzufolge kann vorgesehen sein, dass
i) ein Anteil an benachbarten Kühlvorrichtungen 5, deren Schlaufen 6a, 6b zueinander geneigt sind, bezogen auf die Hauptflussrichtung F des Kühlfluids, stromaufwärts geringer ist als stromabwärts beziehungsweise ein Anteil an benachbarten Kühlvorrichtungen 5, deren Schlaufen 6a, 6b zueinander geneigt sind, in der Nähe des Einlasses 8 des Kühlkanals K geringer ist als in der Nähe des Auslasses 9 des Kühlkanals K und/oder
ii) die Höhe der Kühlvorrichtungen 5, bezogen auf die Hauptflussrichtung F des Kühlfluids, stromaufwärts geringer ist als stromabwärts beziehungsweise die Höhe der Kühlvorrichtungen 5 in der Nähe des Einlasses 8 des Kühlkanals K geringer ist als in der Nähe des Auslasses 9 des Kühlkanals K und/oder
iii) ein Anteil an benachbarten Kühlvorrichtungen 5, deren Schlaufen 6a, 6b in einer Längsrichtung der Kühlvorrichtungen zueinander versetzt sind, bezogen auf die Hauptflussrichtung F des Kühlfluids, stromaufwärts geringer ist als stromabwärts beziehungsweise ein Anteil an benachbarten Kühlvorrichtungen, deren Schlaufen 6a, 6b in einer Längsrichtung der Kühlvorrichtungen 5 zueinander versetzt sind, in der Nähe des Einlasses 8 des Kühlkanals K geringer ist als in der Nähe des Auslasses 9 des Kühlkanals K und/oder
iv) ein Versatz von Schlaufen 6a, 6b benachbarter Kühlvorrichtungen 5, bezogen auf die Hauptflussrichtung F des Kühlfluids, stromabwärts geringer ist als stromaufwärts beziehungsweise ein Versatz von Schlaufen 6a, 6b benachbarter Kühlvorrichtungen 5 in der Nähe des Auslasses 9 des Kühlkanals K geringer ist als in der Nähe des Einlasses 8 des Kühlkanals K und/oder
v) ein Anteil an benachbarten Kühlvorrichtungen 5, deren Augen in unterschiedliche Richtungen zeigen, stromaufwärts geringer ist als stromabwärts beziehungsweise ein Anteil an benachbarten Kühlvorrichtungen 5, deren Augen in unterschiedliche Richtungen zeigen, in der Nähe des Einlasses 8 des Kühlkanals K geringer ist als in der Nähe des Auslasses 9 des Kühlkanals K und/oder
vi) eine Verdrehung von Schlaufen 6a, 6b benachbarter Kühlvorrichtungen 5, bezogen auf die Hauptflussrichtung F des Kühlfluids, stromaufwärts geringer ist als stromabwärts beziehungsweise eine Verdrehung von Schlaufen 6a, 6b benachbarter Kühlvorrichtungen 5 in der Nähe des Einlasses 8 des Kühlkanals K geringer ist als in der Nähe des Auslasses 9 des Kühlkanals K.

Die in den Punkten a) bis f) beziehungsweise i) bis vi) offenbarten Maßnahmen können sich graduell ändern oder auch sprunghaft. Mit anderen Worten kann eine Änderung der in den Punkten a) bis f) und i) bis vi) offenbarten Maßnahmen von Kühlvorrichtung 5 zu Kühlvorrichtung 5 erfolgen, oder es erfolgt eine relativ drastische Änderung zwischen zwei benachbarten Kühlvorrichtungen 5, und die Maßnahmen bleiben dann über mehrere Kühlvorrichtungen 5 hinweg konstant. Insbesondere können die in einem Bereich eines Schalters S1..S3' ergriffenen Maßnahmen gleich bleiben, zwischen mehreren oder allen Schaltern S1..S3' aber Unterschiede in den ergriffenen Maßnahmen vorliegen.

Vorzugsweise unterscheiden sich die in den Punkten a) bis f) beziehungsweise i) bis vi) ergriffenen Maßnahmen für eine Gruppe erster Schalter S1, S1', welche einer Halbbrücke des Wechselrichters 2 zugeordnet sind, von den in den Punkten a) bis f) oder i) bis vi) ergriffenen Maßnahmen für eine Gruppe zweiter Schalter S2..S3', welche anderen Halbbrücken des Wechselrichters 2 zugeordnet sind, wobei innerhalb einer Gruppe jedoch keine Unterschiede der in den Punkten a) bis f) oder i) bis vi) ergriffenen Maßnahmen vorgesehen sind und wobei die ersten Schalter S1, S1'gegenüber den zweiten Schaltern S2..S3' in einer Hauptflussrichtung F des Kühlfluids stromabwärts angeordnet sind. Mit anderen Worten kann insbesondere vorgesehen sein, dass sich im Hinblick auf die in den Punkten a) bis f) oder i) bis vi) ergriffenen Maßnahmen nur die Schalter S1, S1' einer am weitesten stromabwärts angeordneten Halbbrücke von den Schaltern S2..S3' aller anderen Halbbrücken unterscheiden.

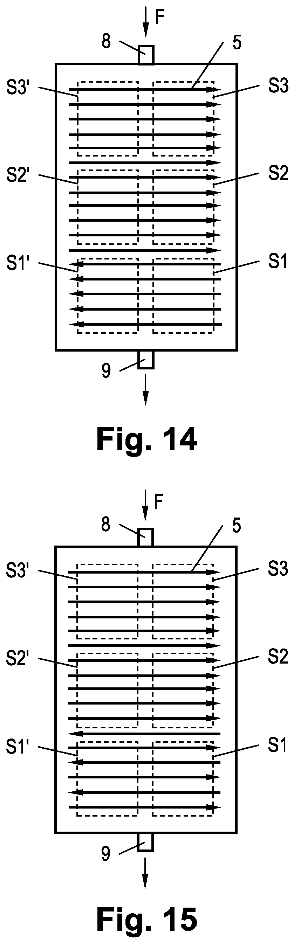

Fig. 14 zeigt dazu ein Beispiel, bei dem die Schlaufen 6a im Bereich der Gruppe erster Schalter S1, S1' nach links geneigt sind und die Schlaufen 6b im Bereich der Gruppe zweiter Schalter S2..S3' nach rechts.

Fig. 15 zeigt weiteres ein Beispiel, bei dem die Schlaufen 6a im Bereich der Gruppe erster Schalter S1, S1' abwechselnd nach links und nach rechts geneigt sind und die Schlaufen 6b im Bereich der Gruppe zweiter Schalter S2..S3' nur nach rechts.

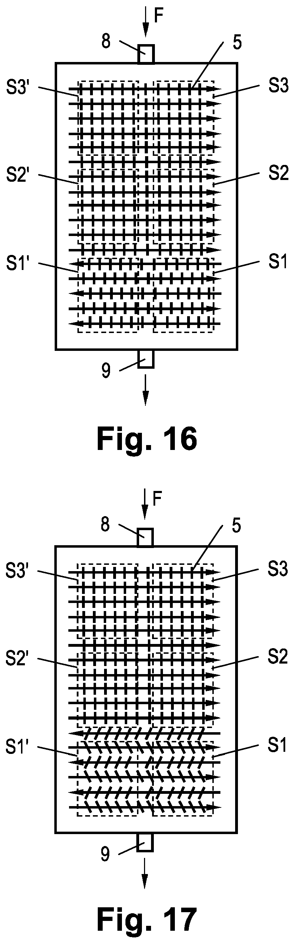

Die Pfeile stehen in den Fig. 14 und 15 wieder stellvertretend für die Neigung der Schlaufen 6a, 6b, sie können aber auch eine unterschiedliche Höhe der Schlaufen 6a, 6b, einen Versatz der Schlaufen 6a, 6b oder eine unterschiedliche Verdrehung der Schlaufen 6a, 6b sowie eine beliebige Kombination der vorgeschlagenen Maßnahmen andeuten. Die Fig. 16 und 17 zeigen diesbezüglich etwas detailliertere Darstellungen, bei dem die Pfeilrichtung wiederum die Neigungsrichtung der Schlaufen 6a, 6b angibt, die Querstriche zusätzlich aber auch Lage und Orientierung der Schlaufen 6a, 6b angeben. Fig. 16 offenbart demzufolge eine Ausführungsform, bei der die Schlaufen 6a im Bereich der Gruppe erster Schalter S1, S1' abwechselnd nach links und nach rechts geneigt und zusätzlich gegeneinander versetzt sind und die Schlaufen 6b im Bereich der Gruppe zweiter Schalter S2..S3' nur nach rechts geneigt und auch nicht gegeneinander versetzt sind. Fig. 17 offenbart zudem eine Ausführungsform, bei der die Schlaufen 6a im Bereich der Gruppe erster Schalter S1, S1' abwechselnd nach links und nach rechts geneigt und zusätzlich gegeneinander verdreht sind und die Schlaufen 6b im Bereich der Gruppe zweiter Schalter S2..S3' nur nach rechts geneigt und auch nicht gegeneinander verdreht sind.

Die Fig. 18 zeigt schließlich den in ein Fahrzeug 10 eingebaute elektrischen Antrieb 3. Das Fahrzeug 10 weist wenigstens zwei Achsen auf, von denen wenigstens eine angetrieben ist. Konkret ist der elektrische Antrieb 3 über ein optionales Getriebe mit den Halbachsen 11 der Hinterachse verbunden. An den Halbachsen 11 sind schließlich die angetriebenen Räder 12 montiert. Der Antrieb des Fahrzeugs 10 erfolgt zumindest teilweise oder zeitweise durch den elektrischen Antrieb 3. Das heißt, der elektrische Antrieb 3 kann zum alleinigen Antrieb des Fahrzeugs 10 dienen oder zum Beispiel im Verbund mit einer Verbrennungskraftmaschine vorgesehen sein (Hybridantrieb).

Abschließend wird festgehalten, dass der Schutzbereich durch die Patentansprüche bestimmt ist. Die Beschreibung und die Zeichnungen sind jedoch zur Auslegung der Ansprüche heranzuziehen. Die in den Figuren enthaltenen Merkmale können beliebig ausgetauscht und miteinander kombiniert werden. Insbesondere wird auch festgehalten, dass die dargestellten Vorrichtungen in der Realität auch mehr oder auch weniger Bestandteile als dargestellt umfassen können. Teilweise können die dargestellten Vorrichtungen beziehungsweise deren Bestandteile auch unmaßstäblich und/oder vergrößert und/oder verkleinert dargestellt sein.

## Patentansprüche

1. Leistungsmodul (1) für ein leistungselektronisches Gerät, insbesondere für einen Wechselrichter (2), umfassend
- eine Grundplatte (4) mit einer ersten Grundplatten-Seite (A) und einer zweiten, gegenüberliegenden Grundplatten-Seite (B),
- steuerbare, elektronische Schalter (S, S1..S3'), welche auf der ersten Grundplatten-Seite (A) angeordnet oder zumindest mit dieser thermisch gekoppelt sind,
- Eingänge (E1, E2) und Ausgänge (A1..A3), welche mit den elektronischen Schaltern (S, S1..S3') elektrisch verbunden sind, wobei das Leistungsmodul (1) dazu ausgebildet ist, eine an den Eingängen (E1, E2) anliegende Eingangsspannung (U) mittels der elektronischen Schalter (S, S1..S3') in eine an den Ausgängen (A1..A3) anliegende Ausgangsspannung umzuwandeln, und
- mehrere auf der zweiten Grundplatten-Seite (B) befestigte oder zumindest mit dieser thermisch gekoppelte Kühlvorrichtungen (5),
**dadurch gekennzeichnet, dass** die Kühlvorrichtungen (5) jeweils mehrere hintereinander angeordnete Schlaufen (6, 6a, 6b) aufweisen und
- die Schlaufen (6a) einer ersten Gruppe der Kühlvorrichtungen (5) und die Schlaufen (6b) einer zweiten Gruppe der Kühlvorrichtungen (5) unterschiedlich weit von der zweiten Grundplatten-Seite (B) abstehen.

2. Leistungsmodul (1) nach Anspruch 1, **dadurch gekennzeichnet, dass** die Schlaufen (6a) der ersten Gruppe der Kühlvorrichtungen (5) gegenüber den Schlaufen (6b) der zweiten Gruppe der Kühlvorrichtungen (5) geneigt sind.

3. Leistungsmodul (1) nach Anspruch 1 oder 2, **dadurch gekennzeichnet, dass** durch die Schlaufen (6, 6a, 6b) gebildete Augen benachbarter Kühlvorrichtungen (5) in einer Längsrichtung der Kühlvorrichtungen (5) zueinander versetzt sind.

4. Leistungsmodul (1) nach Anspruch 1 bis 3, **dadurch gekennzeichnet, dass** alle Augen, welche durch die Schlaufen (6, 6a, 6b) gebildet sind, in dieselbe Richtung zeigen.

5. Leistungsmodul (1) nach einem der Ansprüche 1 bis 4, **dadurch gekennzeichnet, dass** die Schlaufen (6, 6a, 6b) gegenüber der Längsrichtung der Kühlvorrichtung (5) verdreht sind.

6. Leistungsmodul (1) nach einem der Ansprüche 1 bis 5, **dadurch gekennzeichnet, dass**
a) ein Anteil an benachbarten Kühlvorrichtungen (5), deren Schlaufen (6, 6a, 6b) zueinander geneigt sind, im Bereich eines ersten Schalters (S1, S1') der Schalter (S, S1..S3') größer ist als im Bereich eines zweiten Schalters (S2, S2') der Schalter (S, S1..S3') und/oder
b) die Höhe der Kühlvorrichtungen (5) im Bereich des ersten Schalters (S1, S1') größer ist als im Bereich des zweiten Schalters (S2, S2') und/oder
c) ein Anteil an benachbarten Kühlvorrichtungen (5), deren Schlaufen (6, 6a, 6b) in einer Längsrichtung der Kühlvorrichtungen (5) zueinander versetzt sind, im Bereich des ersten Schalters (S1, S1') größer ist als im Bereich des zweiten Schalters (S2, S2') und/oder
d) ein Versatz von Schlaufen (6, 6a, 6b) benachbarter Kühlvorrichtungen (5) im Bereich des ersten Schalters (S1, S1') geringer ist als im Bereich des zweiten Schalters (S2, S2') und/oder
e) ein Anteil an benachbarten Kühlvorrichtungen (5), deren Augen in unterschiedliche Richtungen zeigen, im Bereich des ersten Schalters (S1, S1') größer ist als im Bereich des zweiten Schalters (S2, S2') und/oder
f) eine Verdrehung von Schlaufen (6, 6a, 6b) benachbarter Kühlvorrichtungen (5) im Bereich des ersten Schalters (S1, S1') größer ist als im Bereich des zweiten Schalters (S2, S2').

7. Leistungselektronisches Gerät, umfassend ein Gerätegehäuse und ein darin angeordnetes Leistungsmodul (1) nach einem der Ansprüche 1 bis 6, wobei die Grundplatte (4) des Leistungsmoduls (1) mit der zweiten Grundplatten-Seite (B) auf eine Aufnahme (7) im Gerätegehäuse aufgesetzt ist und wobei ein Kühlkanal (K) geformt ist, welcher
- teilweise von der zweiten Grundplatten-Seite (B) begrenzt ist,
- die Kühlvorrichtungen (5) aufnimmt.
- einen Einlass (8) zum Anschluss an einen Kühlkreislauf und für einen Zustrom eines Kühlfluids aufweist,
- einen Auslass (9) zum Anschluss an den Kühlkreislauf und für einen Abfluss des Kühlfluids aufweist und
- der im Betrieb von einem Kühlfluid in einer Hauptflussrichtung (F) vom Einlass (8) zum Auslass (9) durchströmt wird.

8. Leistungselektronisches Gerät nach Anspruch 7, **dadurch gekennzeichnet, dass** eine Längsrichtung der Kühlvorrichtungen (5) quer zur Hauptflussrichtung (F) des Kühlfluids ausgerichtet ist und Augen, welche durch die Schlaufen (6, 6a, 6b) gebildet sind, in Richtung der Hauptflussrichtung (F) des Kühlfluids offen sind.

9. Leistungselektronisches Gerät nach Anspruch 7 oder 8, **dadurch gekennzeichnet, dass** ein erster Schalter (S1, S1') gegenüber einem zweiten Schalter (S2, S2') in der Hauptflussrichtung (F) des Kühlfluids stromabwärts angeordnet ist.

10. Leistungselektronisches Gerät nach Anspruch 7, **dadurch gekennzeichnet, dass** in dem leistungselektronischen Gerät ein Leistungsmodul (1) nach Anspruch 6 angeordnet ist und dass sich die in den Punkten a) bis f) ergriffenen Maßnahmen für eine Gruppe erster Schalter (S1, S1'), welche einer Halbbrücke des Wechselrichters (2) zugeordnet sind, von den in den Punkten a) bis f) ergriffenen Maßnahmen für eine Gruppe zweiter Schalter (S2..S3'), welche anderen Halbbrücken des Wechselrichters (2) zugeordnet sind, unterscheiden, innerhalb einer Gruppe jedoch keine Unterschiede der in den Punkten a) bis f) ergriffenen Maßnahmen vorgesehen sind, wobei die ersten Schalter (S1, S1') gegenüber den zweiten Schaltern (S2..S3') in einer Hauptflussrichtung (F) des Kühlfluids stromabwärts angeordnet sind.

11. Als Wechselrichter ausgebildetes leistungselektronisches Gerät nach einem der Ansprüche 7 bis 10, aufweisend einen im Gerätegehäuse angeordneten Zwischenkreiskondensator (C), der mit den Eingängen (E1, E2) des Leistungsmoduls (1) elektrisch verbunden ist, wobei das Leistungsmodul (1) eingerichtet ist, eine an den Eingängen (E1, E2) anliegende Gleichspannung in eine an den Ausgängen anliegende Wechselspannung umzuwandeln.

12. Elektrischer Antrieb (3), umfassend einen Wechselrichter (2) nach Anspruch 11 und eine an die Ausgänge (A1..A3) des Leistungsmoduls (1) angeschlossene elektrische Maschine (M).

## Claims

1. Power module (1) for a power electronic device, in particular for an inverter (2), comprising
- a base plate (4) with a first base plate side (A) and a second, opposite base plate side (B),
- controllable electronic switches (S, S1..S3') which are arranged on the first base plate side (A) or are at least thermally coupled to it,
- inputs (E1, E2) and outputs (A1..A3) which are electrically connected to the electronic switches (S, S1..S3'), wherein the power module (1) is designed to convert an input voltage (U) applied to the inputs (E1, E2) into an output voltage applied to the outputs (A1..A3) by means of the electronic switches (S, S1..S3'), and
- a plurality of cooling devices (5) fixed to the second base plate side (B) or at least thermally coupled thereto,
**characterised in that** the cooling devices (5) each have a plurality of loops (6, 6a, 6b) arranged one behind the other and
- the loops (6a) of a first group of cooling devices (5) and the loops (6b) of a second group of cooling devices (5) protrude at different distances from the second base plate side (B).

2. Power module (1) according to claim 1, **characterised in that** the loops (6a) of the first group of cooling devices (5) are inclined relative to the loops (6b) of the second group of cooling devices (5).

3. Power module (1) according to claim 1 or 2, **characterised in that** the eyes formed by the loops (6, 6a, 6b) of adjacent cooling devices (5) are offset from each other in a longitudinal direction of the cooling devices (5).

4. Power module (1) according to claims 1 to 3, **characterised in that** all eyes formed by the loops (6, 6a, 6b) point in the same direction.

5. Power module (1) according to one of claims 1 to 4, **characterised in that** the loops (6, 6a, 6b) are twisted relative to the longitudinal direction of the cooling device (5).

6. Power module (1) according to one of claims 1 to 5, **characterised in that**
a) a proportion of adjacent cooling devices (5) whose loops (6, 6a, 6b) are inclined towards each other in the area of a first switch (S1, S1') of the switches (S, S1..S3') is greater than in the region of a second switch (S2, S2') of the switches (S, S1..S3') and/or
b) the height of the cooling devices (5) in the region of the first switch (S1, S1') is greater than in the region of the second switch (S2, S2') and/or
c) a proportion of adjacent cooling devices (5) whose loops (6, 6a, 6b) are offset from one another in a longitudinal direction of the cooling devices (5) is greater in the region of the first switch (S1, S1') than in the region of the second switch (S2, S2') and/or
d) an offset of loops (6, 6a, 6b) of neighbouring cooling devices (5) in the area of the first switch (S1, S1') is smaller than in the area of the second switch (S2, S2') and/or
e) a proportion of adjacent cooling devices (5) whose eyes point in different directions is greater in the area of the first switch (S1, S1') than in the area of the second switch (S2, S2') and/or
f) a twist of loops (6, 6a, 6b) of adjacent cooling devices (5) in the region of the first switch (51, S1') is greater than in the region of the second switch (S2, S2').

7. Power electronic device comprising a device housing and a power module (1) arranged therein according to one of claims 1 to 6, wherein the base plate (4) of the power module (1) is placed with the second base plate side (B) on a receptacle (7) in the device housing and wherein a cooling channel (K) is formed which
- is partially bounded by the second base plate side (B),
- accommodates the cooling devices (5).
- has an inlet (8) for connection to a cooling circuit and for an inflow of a cooling fluid,
- has an outlet (9) for connection to the cooling circuit and for an outflow of the cooling fluid, and
- is traversed during operation by a cooling fluid in a main flow direction (F) from the inlet (8) to the outlet (9).

8. Power electronic device according to claim 7, **characterised in that** a longitudinal direction of the cooling devices (5) is aligned transversely to the main flow direction (F) of the cooling fluid and eyes formed by the loops (6, 6a, 6b) are open in the direction of the main flow direction (F) of the cooling fluid.

9. Power electronic device according to claim 7 or 8, **characterised in that** a first switch (S1, S1') is arranged downstream of a second switch (S2, S2') in the main flow direction (F) of the cooling fluid.

10. Power electronic device according to claim 7, **characterised in that** a power module (1) according to claim 6 is arranged in the power electronic device and **in that** the measures taken in points a) to f) for a group of first switches (S1, S1') which are assigned to a half-bridge of the inverter (2) differ from the measures taken in points a) to f) for a group of second switches (S2..S3') assigned to other half-bridges of the inverter (2), but no differences in the measures taken in points a) to f) are provided within a group, wherein the first switches (S1, S1') are arranged downstream of the second switches (S2..S3') in a main flow direction (F) of the cooling fluid.

11. Power electronic device designed as an inverter according to one of claims 7 to 10, comprising a flyback capacitor (C) arranged in the device housing, which is electrically connected to the inputs (E1, E2) of the power module (1), wherein the power module (1) is designed to convert a DC voltage applied to the inputs (E1, E2) to an alternating voltage present at the outputs.

12. Electric drive (3) comprising an inverter (2) according to claim 11 and an electric machine (M) connected to the outputs (A1..A3) of the power module (1).

## Revendications

1. Module de puissance (1) pour un appareil électronique de puissance, en particulier pour un onduleur (2), comprenant
- une plaque de base (4) avec un premier côté de plaque de base (A) et un deuxième côté de plaque de base (B) opposé,
- des commutateurs électroniques commandables (S, S1..S3') qui sont disposés sur le premier côté de la plaque de base (A) ou au moins couplés thermiquement à celui-ci,
- des entrées (E1, E2) et des sorties (A1..A3) qui sont reliées électriquement aux commutateurs électroniques (S, 51..53'), le module de puissance (1) étant conçu pour convertir une tension d'entrée (U) appliquée aux entrées (E1, E2) en une tension de sortie appliquée aux sorties (A1..A3) à l'aide des commutateurs électroniques (S, S1..S3'), et
- plusieurs dispositifs de refroidissement (5) fixés sur le deuxième côté de la plaque de base (B) ou au moins couplés thermiquement à celle-ci,
**caractérisé en ce que** les dispositifs de refroidissement (5) comportent chacun plusieurs boucles (6, 6a, 6b) disposées les unes derrière les autres et
- les boucles (6a) d'un premier groupe des dispositifs de refroidissement (5) et les boucles (6b) d'un deuxième groupe des dispositifs de refroidissement (5) sont espacées différemment de la deuxième face (B) de la plaque de base.

2. Module de puissance (1) selon la revendication 1, **caractérisé en ce que** les boucles (6a) du premier groupe de dispositifs de refroidissement (5) sont inclinées par rapport aux boucles (6b) du deuxième groupe de dispositifs de refroidissement (5).

3. Module de puissance (1) selon la revendication 1 ou 2, **caractérisé en ce que** les œillets formés par les boucles (6, 6a, 6b) de dispositifs de refroidissement (5) adjacents sont décalés les uns par rapport aux autres dans une direction longitudinale des dispositifs de refroidissement (5).

4. Module de puissance (1) selon les revendications 1 à 3, **caractérisé en ce que** tous les œillets formés par les boucles (6, 6a, 6b) sont orientés dans la même direction.

5. Module de puissance (1) selon l'une des revendications 1 à 4, **caractérisé en ce que** les boucles (6, 6a, 6b) sont tournées par rapport à la direction longitudinale du dispositif de refroidissement (5).

6. Module de puissance (1) selon l'une des revendications 1 à 5, **caractérisé en ce que**
a) une partie des dispositifs de refroidissement (5) voisins dont les boucles (6, 6a, 6b) sont inclinées les unes par rapport aux autres, dans la zone d'un premier interrupteur (S1, S1'), des interrupteurs (S, S1..S3') est supérieure à celle dans la zone d'un deuxième interrupteur (S2, S2') des interrupteurs (S, S1..S3') et/ou
b) la hauteur des dispositifs de refroidissement (5) dans la zone du premier interrupteur (S1, S1') est supérieure à celle dans la zone du deuxième interrupteur (S2, S2') et/ou
c) une proportion de dispositifs de refroidissement adjacents (5) dont les boucles (6, 6a, 6b) sont décalées les unes par rapport aux autres dans une direction longitudinale des dispositifs de refroidissement (5) est plus grande dans la zone du premier commutateur (S1, S1') que dans la zone du deuxième commutateur (S2, 52') et/ou
d) un décalage des boucles (6, 6a, 6b) de dispositifs de refroidissement voisins (5) dans la zone du premier interrupteur (S1, S1') est inférieur à celui dans la zone du deuxième interrupteur (S2, S2') et/ou
e) une proportion de dispositifs de refroidissement voisins (5) dont les yeux sont orientés dans des directions différentes est plus grande dans la zone du premier interrupteur (S1, S1') que dans la zone du deuxième interrupteur (S2, S2') et/ou
f) une torsion des boucles (6, 6a, 6b) de dispositifs de refroidissement voisins (5) dans la zone du premier interrupteur (S1, S1') est plus importante que dans la zone du deuxième interrupteur (S2, S2').

7. Appareil électronique de puissance, comprenant un boîtier d'appareil et un module de puissance (1) disposé dans celui-ci selon l'une des revendications 1 à 6, la plaque de base (4) du module de puissance (1) étant posée avec le deuxième côté de plaque de base (B) sur un logement (7) dans le boîtier d'appareil et un canal de refroidissement (K) étant formé, lequel
- est partiellement délimité par le deuxième côté de la plaque de base (B),
- reçoit les dispositifs de refroidissement (5).
- une entrée (8) pour le raccordement à un circuit de refroidissement et pour l'arrivée d'un fluide de refroidissement,
- une sortie (9) pour le raccordement au circuit de refroidissement et pour l'évacuation du fluide de refroidissement, et
- qui, en fonctionnement, est traversé par un fluide de refroidissement dans une direction d'écoulement principale (F) allant de l'entrée (8) à la sortie (9).

8. Appareil électronique de puissance selon la revendication 7, **caractérisé en ce qu'**une direction longitudinale des dispositifs de refroidissement (5) est orientée transversalement à la direction d'écoulement principale (F) du fluide de refroidissement et que des œillets formés par les boucles (6, 6a, 6b) sont ouverts dans la direction d'écoulement principale (F) du fluide de refroidissement.

9. Appareil électronique de puissance selon la revendication 7 ou 8, **caractérisé en ce qu'**un premier interrupteur (S1, S1') est disposé en aval d'un deuxième interrupteur (S2, S2') dans la direction d'écoulement principale (F) du fluide de refroidissement.

10. Appareil électronique de puissance selon la revendication 7, **caractérisé en ce qu'**un module de puissance (1) selon la revendication 6 est disposé dans l'appareil électronique de puissance et **en ce que** les mesures prises aux points a) à f) pour un groupe de premiers commutateurs (S1, S1') qui sont associés à un demi-pont de l'onduleur (2) se distinguent des mesures prises aux points a) à f) pour un groupe de deuxièmes commutateurs (S2..S3') qui sont associés à d'autres demi-ponts de l'onduleur (2), mais qu'aucune différence n'est prévue au sein d'un groupe entre les mesures prises aux points a) à f) pour un groupe de deux commutateurs (S1, S1') qui sont associés à un demi-pont de l'onduleur (2) et pour un groupe de deux commutateurs (S2..S3') qui sont associés à d'autres demi-ponts de l'onduleur (2), les premiers commutateurs (S1, S1') étant disposés en aval des deuxièmes commutateurs (S2..S3') dans une direction principale d'écoulement (F) du fluide de refroidissement.

11. Appareil électronique de puissance conçu comme un onduleur selon l'une des revendications 7 à 10, comportant un condensateur de circuit intermédiaire (C) disposé dans le boîtier de l'appareil, qui est relié électriquement aux entrées (E1, E2) du module de puissance (1), le module de puissance (1) étant agencé pour convertir une tension continue appliquée aux entrées (E1, E2) en une tension alternative aux sorties.

12. Entraînement électrique (3) comprenant un onduleur (2) selon la revendication 11 et une machine électrique (M) raccordée aux sorties (A1..A3) du module de puissance (1).
